# EUROPÄISCHE PATENTANMELDUNG

(11) **EP 1 947 550 A1**
(43) Veröffentlichungstag der Anmeldung: **23.07.2008**
(21) Anmeldenummer: 07123476.9
(22) Anmeldetag: 18.12.2007
(51) Int. Cl.: G06F 3/042, H03K 17/96

(54) **Eingabevorrichtung für ein Haushaltsgerät**

(30) Priorität: 29.12.2006 DE 102006062071
(71) Anmelder: BSH Bosch und Siemens Hausgeräte GmbH, 81739 München (DE)
(72) Erfinder: Mager, Gerhard, 90556, Cadolzburg (DE); Mayer, Herbert, 93077, Bad Abbach (DE); Werkmann, Horst, 85276, Pfaffenhofen/Ilm (DE)

(57) **Zusammenfassung**

Die Erfindung bezieht sich auf eine opto-elektronische Eingabevorrichtung (1), insbesondere für Haushaltsgeräte, mit einer Lichtquelle (4), einem Lichtdetektor (5) und einem Lichtleiter (8), der einen Lichteingang (11) zur Einkopplung von Licht der Lichtquelle (4) und einen Lichtausgang (12) zur Detektion des in dem Lichtleiter (8) geführten Lichts durch den Lichtdetektor (5) aufweist, wobei die Eingabevorrichtung (1) eine Berührfläche (30) aufweist und derart ausgebildet ist, dass durch Berührung der Berührfläche (30) ein evaneszentes Feld des im Lichtleiter (8) geführten Lichts veränderbar und eine daraus folgende Veränderung des in dem Lichtleiter (8) geführten Lichts mit dem Lichtdetektor (5) detektierbar ist.

Die Berührfläche (30) ist in Form eines Stellstreifens (27) ausgebildet, wobei sich der Lichtleiter (8) und damit das evaneszente Feld des in dem Lichtleiter (8) geführten Lichts entlang des Stellstreifens (27) erstreckt und wobei bei Berührung des Stellstreifens (27) an einer Berührposition diese Berührposition anhand der Veränderung des in dem Lichtleiter (8) geführten Lichts bestimmbar und als Schaltsignal auswertbar ist.

## Beschreibung

Die Erfindung bezieht sich auf eine opto-elektronische Eingabevorrichtung, insbesondere für Haushaltsgeräte, mit einer Lichtquelle, einem Lichtdetektor und einem Lichtleiter, der einen Lichteingang zur Einkopplung von Licht der Lichtquelle und einen Lichtausgang zur Detektion des in dem Lichtleiter geführten Lichts durch den Lichtdetektor aufweist, wobei die Eingabevorrichtung eine Berührfläche aufweist und derart ausgebildet ist, dass durch Berührung der Berührfläche ein evaneszentes Feld des im Lichtleiter geführten Lichts veränderbar und eine daraus folgende Veränderung des in dem Lichtleiter geführten Lichts mit dem Lichtdetektor detektierbar ist, und auf ein Haushaltsgerät mit solch einer Eingabevorrichtung.

Solch eine Eingabevorrichtung ist bereits aus DE 10 2005 021 008 A1 bekannt. Dort wird bei einem optischen Schalter eine Störung eines evaneszenten Feldes zur Ausübung der Schalterfunktion ausgenutzt. Hierbei ist ein optisches Element vorgesehen, an dessen Außenoberfläche im Bereich einer Berührungsfläche im berührungslosen Zustand eine Lichtreflexion auftritt. Wird der Schalter betätigt, so wird das sich an der Außenoberfläche ausbreitende evaneszente Feld im Bereich der Berührungsfläche und damit die Lichtausbreitung in dem optischen Element gestört, was zu einer Signalschwächung führt und als Schaltsignal ausgewertet wird. Das optische Element ist hierbei insbesondere ein Prisma oder ein Lichtwellenleiter, bei dem zur Erhöhung der sensitiven Fläche vorgesehen ist, dass der Querschnitt des Lichtwellenleiters abgeflacht ist, oder dass der Lichtwellenleiter nach Art einer Wendel oder einer Spirale geführt ist.

Aus DE 10 2005 021 008 A1 ist weiterhin bekannt, mehrere einzelne Schalter zu einem Schieberegler nebeneinander anzuordnen. Durch einfaches Berühren der Oberflächen der einzelnen Schalter werden hierbei die einzelnen Schalter aktiviert. Der Zustand der aktivierten Schalter wird hierbei durch Leuchten des Schalters selbst angezeigt, so dass sich insofern eine Art Pegelanzeige ergibt. Die einzelnen Schalter sind Zweckdienlicherweise miteinander derart verschaltet, dass sie nur aufeinander folgend geschaltet werden können, wie dies bei einem Schieberegler der Fall ist. Eine Eingabevorrichtung mit solch ein Schieberegler hat allerdings den Nachteil, dass durch Montage der einzelnen Schalter mit den jeweils zugehörigen optischen Elementen die Herstellung der Eingabevorrichtung insgesamt teuer ist.

Der vorliegenden Erfindung liegt daher die Aufgabe zugrunde, eine verbesserte, kostengünstige Eingabevorrichtung zur Verfügung zu stellen.

Gelöst wird die vorstehend aufgezeigte Aufgabe durch eine opto-elektronische Eingabevorrichtung mit den Merkmalen des Anspruchs 1. Vorteilhafte sowie bevorzugte Ausgestaltungen der Erfindung sind Gegenstand der abhängigen Ansprüche.

Da der einleitend genannte Schieberegler mit Hilfe berührungsempfindlicher Sensoren gebildet ist und im Gegensatz zum Verschieben eines mechanischen Schiebers lediglich durch Berührung einer zugehörigen Bedienfläche betätigt wird, wird solch ein Schieberegler im Folgenden "Stellstreifen" genannt. Dabei ist es unerheblich, ob der Stellstreifen analog zu einem Schieberegler linear ausgebildet ist oder analog zu einem Drehknebel kreis- bzw. ringförmig. Wesentlich ist nur, dass verschiedenen Bereichen des Stellstreifens verschiedene Stellwerte zugeordnet sein können, die durch Berührung des jeweiligen Bereichs bzw. Gleiten entlang des Stellstreifens einstellbar sind.

Grundgedanke der Erfindung ist es, anhand einer durch eine Berührung des Stellstreifens hervorgerufene Veränderung des von einem oder mehreren Sendeelementen stammenden, an dieser Position des Stellstreifens reflektierten oder gestreuten Lichts diese Position der Berührung zu bestimmen und einen entsprechenden Schaltvorgang auszulösen. Dabei wird der Umstand genutzt, dass bei Reflexion, insbesondere bei Totalreflexion, von Licht an einer Grenzfläche evaneszente Wellen auftreten. Solche evaneszenten Wellen oder Felder treten in einem Bereich auf, in dem bei klassischer Betrachtungsweise kein Feld existieren sollte. Ihre Existenz erklärt sich quantenmechanisch aus der Aufenthaltswahrscheinlichkeit eines Photons, welche sich auch auf den Bereich in oder hinter einem Reflektor erstreckt. Evaneszente Wellen treten z.B. in oder hinter Flächen auf, an denen Wellen reflektiert werden. Da keine Energie wegtransportiert wird, gilt dies auch bei vollständiger Reflexion und Totalreflexion an einer Grenzfläche transparenter Materialien. D.h. einfacher gesagt, dass auch bei Totalreflexion von Licht an der Grenzfläche ein Teil des Lichts die Grenzfläche durchdringt und von dem dahinter liegenden Material zurück geworfen oder gebeugt wird. Bei einer Veränderung oder Störung des dahinter liegenden Materials wird auch das evaneszente Feld verändert oder gestört. Dies führt zu einer Veränderung der Reflexion des Lichts an der Grenzfläche, wodurch wiederum das im Lichtleiter geführte, reflektierte Licht verändert, insbesondere gedämpft wird. Im Folgenden werden unter "Licht" elektromagnetische Wellen beliebiger Wellenlänge, insbesondere jedoch sichtbares Licht und Infrarotstrahlung verstanden.

Die erfindungsgemäße opto-elektronische Eingabevorrichtung, die insbesondere für Haushaltsgeräte geeignet ist, weist eine Lichtquelle, einen Lichtdetektor und einen Lichtleiter auf, der einen Lichteingang zur Einkopplung von Licht der Lichtquelle und einen Lichtausgang zur Detektion des in dem Lichtleiter geführten Lichts durch den Lichtdetektor umfasst. Des weiteren weist diese Eingabevorrichtung eine Berührfläche auf und ist derart ausgebildet, dass durch Berührung der Berührfläche ein evaneszentes Feld des im Lichtleiter geführten Lichts veränderbar und eine daraus folgende Veränderung des in dem Lichtleiter geführten Lichts mit dem Lichtdetektor detektierbar ist. Diese Berührfläche ist in Form eines Stellstreifens ausgebildet, wobei sich der Lichtleiter und damit das evaneszente Feld des in dem Lichtleiter geführten Lichts entlang des Stellstreifens erstreckt und wobei bei Berührung des Stellstreifens an einer Berührposition diese Berührposition anhand der Veränderung des in dem Lichtleiter geführten Lichts bestimmbar und als Schaltsignal auswertbar ist.

D.h. das von der Lichtquelle emittierte Licht, insbesondere Infrarotlicht, wird in den Lichtleiter eingekoppelt, in dem Lichtleiter geführt und mittels Totalreflexion z.B. an einer Lichtleitergrenzfläche zu dem Lichtdetektor übertragen. Bei der Totalreflexion bildet sich durch das im Lichtleiter geführte Licht außerhalb des Lichtleiters in einem an den Lichtleiter angrenzenden Medium, wie beispielsweise der Umgebungsluft, das oben genannte evaneszente Feld aus. Durch Veränderung dieses angrenzenden Mediums wird die Ausbildung des evaneszenten Feldes beeinflusst, wodurch wiederum das im Lichtleiter geführte Licht - auch Lichtstrom genannt - beeinflusst, insbesondere gedämpft wird. Wesentlich ist, dass das evaneszente Feld zwar durch das in dem Lichtleiter geführte Licht gebildet wird, sich selbst aber außerhalb des Lichtleiters erstreckt und somit einer Beeinflussung zugänglich ist.

Die Erfindung bringt den Vorteil mit sich, dass sich ein einziger Lichtleiter über den gesamten Stellstreifen erstreckt und somit auf eine Montage von einzelnen Schaltelementen mit jeweils zugeordneten einzelnen Lichtleitern verzichtet werden kann. Auf diese Weise wird der Fertigungsprozess deutlich vereinfacht und somit auch kostengünstiger. Ein weiterer, wesentlicher Vorteil besteht darin, dass durch den durchgängigen Lichtleiter das damit verknüpfte evaneszente Feld den gesamten Stellstreifen ohne Lücken abdeckt, so dass es möglich ist, die Berührposition längs des Stellstreifens kontinuierlich zu bestimmen. Auf diese Weise kann beispielsweise eine kontinuierliche Fingerbewegung entlang des Stellstreifens detektiert werden. Ein weiterer Vorteil beruht darin, dass durch die Verwendung eines einzigen Lichtleiters eine Vielzahl von neuen Designvarianten ermöglicht wird. Zusätzlich kann die Eingabevorrichtung für verschiedene Geräte bzw. Gerätevarianten gleich ausgebildet sein. D.h. eine Anpassung an die verschiedenen Geräte bzw. Gerätevarianten kann auf einfache Weise durch ein Softwareprogramm realisiert werden, mit dem dem Stellstreifen jeweils unterschiedliche Stellwerte und/oder auch unterschiedliche Stellbereiche zugeordnet werden können. Auch bei einem einzelnen Gerät kann mittels Software für den Stellstreifen solch eine unterschiedliche Zuordnung für verschiedene Betriebszustände und/oder Betriebsprogramme des Gerätes durchgeführt werden. Des weiteren kann der Stellstreifen auch per Software aktiviert und/oder deaktiviert werden.

Vorzugsweise weist der Lichtleiter mehrere Lichtausgänge auf, wobei jedem der Lichtausgänge ein Lichtdetektor zugeordnet ist. Solch ein Lichtdetektor kann beispielsweise ein Fototransistor oder eine Fotodiode sein. Die Lichtausgänge sind vorzugsweise über den Lichtleiter verteilt angeordnet, so dass eine Veränderung des den jeweiligen Lichtausgang und damit den jeweils zugeordneten Detektor erreichenden Lichts detektiert werden kann. Anhand dieser Veränderung kann auf einfache Weise die entsprechende Position bestimmt werden, an der der Stellstreifen berührt wird.

Gegebenenfalls weist der Lichtleiter eine Formgebung und/oder Strukturen auf, so dass der Lichtleiter zur Umlenkung des in dem Lichtleiter geführte Lichts zu den Lichtausgängen hin ausgebildet ist. Insbesondere dient die Formgebung und/oder dienen die Strukturen dazu, die Lichtausgänge möglichst gleichmäßig auszuleuchten, d.h. mit Licht zu versorgen. Es sind beispielsweise an einem Rand oder im Inneren des Lichtleiters Reflexionsflächen ausgebildet, durch die das Licht in die Richtung der Lichtausgänge reflektiert wird. Diese Reflexionsflächen können beispielsweise die Form von Prismen aufweisen. Es sind aber auch andere Formen möglich.

Gemäß einer bevorzugten Ausführungsform ist der Lichtleiter derart kammartig ausgebildet, dass er eine Lichtleiterleiste aufweist, die sich entlang des Stellstreifens erstreckt, von der aus Lichtleiterfortsätze abzweigen, deren der Lichtleiterleiste abgewandtes Ende jeweils in einen Lichtausgang mündet. Auf diese Weise können die Lichtausgänge und die Detektoren entfernt von dem Stellstreifen angeordnet sein, ohne dass durch den Weg, den das Licht bis zu dem Lichtausgang zurücklegen muss, die Information über die Berührposition verfälscht wird. Insbesondere wird das Licht durch die Lichtleiterfortsätze gebündelt, so dass die an den Lichtausgängen angeordneten Lichtdetektoren ein deutliches Signal z.B. in Form eines analogen elektrischen Wertes erzeugen können.

Vorzugsweise ist das durch Berührung des Stellstreifens veränderbare evaneszente Feld durch das in der Lichtleiterleiste geführte Licht gebildet. Dadurch erstreckt sich das evaneszente Feld lückenlose längs des Stellstreifens. Des weiteren findet die Veränderung des evaneszenten Feldes und damit des in dem Lichtleiter geführten Lichts durch Berührung des Stellstreifens im Bereich der Lichtleiterleiste statt, bevor das Licht von der Lichtleiterleiste in die Lichtleiterfortsätze übergeht. Dadurch ist trotz der entfernt angeordneten Lichtausgänge eine exakte Bestimmung der Berührposition längs des Stellstreifens gewährleistet.

Insbesondere erstrecken sich die Lichtleiterfortsätze senkrecht zu der Lichtleiterleiste. Auf diese Weise kann eine gleichmäßige Umlenkung des in dem Lichtleiter geführten Lichts von der Lichtleiterleiste aus in die Lichtleiterfortsätze erfolgen. Vorzugsweise sind Reflexionsflächen in einem 45 Grad Winkel zu der Einfallsrichtung des Lichts ausgerichtet.

Gemäß einer bevorzugten Ausführungsform ist die Berührposition anhand von Signalen mehrerer Lichtdetektoren, insbesondere zumindest zweier Lichtdetektoren, bestimmbar. Wird beispielsweise ein Finger kontinuierlich entlang des Stellstreifens geführt, so wird das in dem Lichtleiter geführte Licht, d.h. der Lichtstrom im Lichtleiter nacheinander an aufeinander folgenden Lichtausgängen kontinuierlich gedämpft. Befindet sich der Finger an einer Position des Stellstreifens, die zwischen zwei Lichtleiterfortsätzen bzw. zwischen zwei Lichtausgängen und somit zwischen zwei Detektoren liegt, so kann durch eine Auswertung der Signale dieser beiden Detektoren die Berührposition genau bestimmt werden. Diese Berührposition kann zum Beispiel zum Einstellen von zwischen diskreten Werten des Stellstreifens liegenden Zwischenwerten genutzt werden. D.h. der Stellstreifen kann durch Überstreichen des Betätigungsbereichs oder auch durch Antippen beliebiger Positionen des Betätigungsbereichs entlang des Stellstreifens betätigt werden. Des weiteren kann durch die Auswertung von zumindest zwei Detektorsignalen eine Geschwindigkeit bei Überstreichen des Stellstreifens bestimmt und zur Ansteuerung und/oder zum Aufruf von Gerätefunktionen genutzt werden. Vorzugsweise werden zur Bestimmung der Berührposition die Signale aller dem Lichtleiter zugeordneten Lichtdetektoren ausgewertet. Dies kann insbesondere in Form eines Multiplexsystems realisiert werden.

Je nach Anwendungsfall ist der Lichtleiter derart ausgebildet, dass das evaneszente Feld entlang des Stellstreifens in Form einer Gleichverteilung ausgebildet ist oder dass das evaneszente Feld entlang des Stellstreifens Maxima und Minima ausbildet oder dass sich das evaneszente Feld entlang des Stellstreifens kontinuierlich verändert. Die Form des evaneszenten Feldes kann durch die Anzahl und/oder die Anordnung von Lichteingängen bzw. durch die Form und/oder die Strukturierung des Lichtleiters beeinflusst werden. Zum Beispiel kann der Lichtleiter in diversen Prismenformen ausgebildet sein. Bei einer Eingabevorrichtung bei der mittels Stellstreifen Werte kontinuierlich eingestellt werden sollen, ist beispielsweise eine Gleichverteilung des evaneszenten Feldes längs des Stellstreifens vorteilhaft. Sollen mit Hilfe des Stellstreifens diskrete Werte und eventuell noch einzelne Zwischenwerte eingestellt werden, so ist beispielsweise eine Ausbildung von Reflexionsmaxima des im Lichtleiter geführten Lichtes und damit von Maxima des evaneszenten Feldes an den entsprechenden Berührpositionen sinnvoll. Ist beispielsweise nur ein einziger Lichtausgang vorgesehen, so kann durch ein evaneszentes Feld, dessen Stärke sich entlang des Stellstreifens kontinuierlich verändert, bei Berührung des Stellstreifens anhand der Änderung des Detektorsignals auf die Berührposition geschlossen werden.

Gemäß einer bevorzugten Ausführungsform weist der Lichtleiter zur Ausbildung des evaneszenten Feldes mehrere Lichteingänge auf, denen jeweils eine Lichtquelle zugeordnet ist. Auf diese Weise kann für den gesamten Stellstreifen und für alle Lichtausgänge ein ausreichend hoher Lichtpegel zur Verfügung gestellt werden, der eine Detektion der Veränderung des in dem Lichtleiter geführten Lichts durch eine Berührung des Stellstreifens erlaubt. Zudem können die Lichteingänge entlang des Lichtleiters derart angeordnet werden, dass bei Berührung des Stellstreifens nur das Licht, das den nächstliegenden Lichtausgang bzw. die nächstliegenden Lichtausgänge erreicht, gedämpft wird, und dass das Licht, das die von der Berührposition weiter entfernt liegenden Lichtausgänge erreicht, ungedämpft bleibt. Dazu kann insbesondere auch eine entsprechende Formgebung und/oder Strukturierung des Lichtleiters beitragen.

Bei einer Eingabevorrichtung, bei der der Stellstreifen und/oder der zugeordnete Lichtleiter bzw. die zugeordnete Lichtleiterleiste zwei Enden aufweist, ist bevorzugt an jedem der Enden des Lichtleiters bzw. der Lichtleiterleiste ein Lichteingang ausgebildet, durch den Licht von einer jeweils zugeordneten Lichtquelle in den Lichtleiter bzw. die Lichtleiterleiste einkoppelbar ist. Insbesondere ist solch ein Stellstreifen und/oder Lichtleiter linear oder gebogen ausgebildet. Auf diese Weise kann sichergestellt werden, dass nur der zu der Berührungsposition nächstliegende bzw. die zu der Berührungsposition nächstliegenden Detektoren eine Dämpfung des Lichtstroms detektieren. D.h. für die weiter von der Berührungsposition entfernt liegenden Detektoren kann der Lichtpegel weitestgehend konstant gehalten werden.

Bei einer Eingabevorrichtung, bei der der Stellstreifen und/oder der Lichtleiter bzw. die Lichtleiterleiste ringförmig ausgebildet ist, ist bevorzugt in dem von dem Lichtleiterring umgebenen Bereich eine oder mehrere Lichtquellen angeordnet, deren Licht in den Lichtleiter eingekoppelt wird. D.h. der Lichtleiter weist auf der dem Ringmittelpunkt zugewandten Seite einen oder mehrere Lichteingänge auf. Vorzugsweise sind die Lichtausgänge dann auf der dem Ringmittelpunkt gegenüber liegenden Seite des ringförmigen Lichtleiters bzw. der ringförmigen Lichtleiterleiste angeordnet. Insbesondere sind die Lichtausgänge über den Umfang des Lichtleiters bzw. der Lichtleiterleiste gleichmäßig verteilt. Auf diese Weise kann über den gesamten ringförmigen Stellstreifen eine gleichmäßige Sensitivität bezüglich Berührungen gewährleistet werden. Als Lichtquellen werden zum Beispiel Leuchtdioden, insbesondere Infrarotleuchtdioden eingesetzt, die ihrerseits vorzugsweise um den Ringmittelpunkt des Lichtleiters ringförmig angeordnet sind. Es ist möglich die Anzahl der Lichtquellen, insbesondere der Leuchtdioden bzw. Infrarotleuchtdioden, gegenüber der Anzahl der Lichtausgänge und damit gegenüber der Anzahl der Detektoren zu halbieren, indem jeweils zwei Lichtausgängen eine Lichtquelle zugeordnet wird. Diese Lichtquelle wird dann sinnvollerweise genau zwischen den beiden Lichtausgängen positioniert, um eine nahezu identischen Lichtstrom zu den beiden Lichtausgängen zu gewährleisten. Dadurch wird eine bessere Auswertung der Berührposition zwischen diesen beiden Lichtausgängen und damit eine bessere Identifizierung von Zwischenwerten des Stellstreifens ermöglicht.

Die Eingabevorrichtung kann derart ausgebildet sein, dass bei Berührung des Stellstreifens der Lichtleiter direkt berührt wird. Gemäß einer bevorzugten Ausführungsform ist aber der Lichtleiter von einer Abdeckplatte abgedeckt. Dies kann beispielsweise eine Geräteblende sein, die in verschiedenen Materialien ausgebildet sein kann, wie zum Beispiel Kunststoff, Metall, wie Edelstahl, Aluminium, Titan oder entsprechende Legierungen, Glas oder Glaskeramik. Insbesondere ist bei einem Kochfeld die Abdeckplatte durch eine Glaskeramikplatte gebildet. Auf diese Weise kann die Eingabevorrichtung bei verschiedensten Geräten bzw. Gerätevarianten eingesetzt werden.

Bei einer Ausführungsvariante der Eingabevorrichtung ist die Abdeckplatte lichtleitend ausgebildet, wobei das in dem Lichtleiter geführte Licht in die Abdeckplatte einkoppelt und dort geführt wird, und wobei das durch Berührung des Stellstreifens veränderbare evaneszente Feld durch das in der Abdeckplatte geführte Licht gebildet ist. Auf diese Weise wird das evaneszente Feld direkt durch den Finger des Benutzers bei Berührung der Abdeckplatte im Bereich des Stellstreifens verändert. Die Abdeckplatte kann dabei aus dem selben Material wie der Lichtleiter gebildet sein, was aber nicht zwingend notwendig ist. Es genügt, wenn die Brechzahl des Materials der Abdeckplatte der Brechzahl des Lichtleiters entspricht oder zumindest nahe kommt. Damit Lichtverluste in der Grenzschicht zwischen Lichtleiter und Abdeckplatte zum Beispiel aufgrund von Grenzflächenrauhigkeiten möglichst gering gehalten werden, ist es vorteilhaft zwischen den Lichtleiter und die Abdeckplatte eine lichtdurchlässige Zwischenschicht, beispielsweise in Form eines lichtdurchlässigen Klebers oder Haftvermittlers, einzubringen. Die Brechzahl dieser Zwischenschicht sollte wiederum an die Brechzahl des Lichtleiters bzw. die Brechzahl der Abdeckplatte angepasst sein, so dass das Licht von dem Lichtleiter in die Abdeckplatte und von der Abdeckplatte in den Lichtleiter mit möglichst geringen bzw. keinen Verlusten übergehen kann.

Bei einer anderen Ausführungsvariante der Eingabevorrichtung ist zwischen der Abdeckplatte und dem Lichtleiter ein Körper angeordnet, durch den bei Berührung der Abdeckplatte im Bereich des Stellstreifens das evaneszente Feld des im Lichtleiter geführten Lichts veränderbar ist. Bei dieser Ausführungsform ist die Abdeckplatte zumindest geringfügig elastisch ausgebildet, so dass bei Berührung der Abdeckplatte im Bereich des Stellstreifens entweder der Körper leicht deformiert oder ein Abstand zwischen dem Lichtleiter und diesem Körper verringert wird. D. h. das evaneszente Feld ist in dem Bereich zwischen dem Lichtleiter und dem Körper ausgebildet und kann durch Annäherung bzw. Deformation des Körpers verändert werden.

Zur Erleichterung der Montage der Eingabevorrichtung sind an dem Lichtleiter zur Halterung auf einem Träger Stützelemente und/oder Rastelemente angeformt. Beispielsweise sind an dem Lichtleiter Stifte angeformt, die in entsprechende Öffnungen bzw. Löcher des Trägers eingeführt und dann beispielsweise heiß verstemmt werden können. Es können auch Rastelemente des Lichtleiters mit Gegenrastlagern des Trägers verrastet werden, um einen Halt des Lichtleiters auf dem Träger zu gewährleisten.

Vorzugsweise ist der Träger eine Leiterplatte, so dass die Lichtquellen, beispielsweise in Form von Leuchtdioden, vorzugsweise Infrarotleuchtdioden, und/oder die Lichtdetektoren, beispielsweise in Form von Fototransistoren oder Fotodioden, direkt auf der Leiterplatte angeordnet sein können. Vorzugsweise ist auch eine zugehörige Auswerteelektronik zur Abfrage bzw. Auswertung der Detektorsignale auf der Leiterplatte vorgesehen. Insbesondere ist es möglich auf der Leiterplatte und damit zwischen Leiterplatte und Lichtleiter ein Leuchtelement oder mehrere Leuchtelemente, z.B. in Form von Leuchtdioden, die sichtbares Licht emittieren, oder Elektrolumineszenfolien, zur Beleuchtung des Stellstreifens anzuordnen. Der Lichtleiter kann mit seinen Lichteingängen und seinen Lichtausgängen derart ausgebildet sein, dass das bzw. die Leuchtelemente derart im Bereich des Stellstreifen angeordnet werden können, dass eine direkte Beleuchtung der Berührfläche des Stellstreifens möglich ist. Dies ist auch für verschiedene Formgebungen der Berührfläche möglich. Des weiteren kann je nach Geräteprogramm die Beleuchtung geändert werden, wodurch dem Benutzer die Bedienung erleichtert werden kann.

Das Leuchtelement kann bzw. die Leuchtelemente können zur Kennzeichnung der Sensorfläche und/oder zur Signalisierung verschiedener Schaltzustände des Annäherungsschalters dienen. Dazu können auch Leuchtdioden (LED) in gleichen oder in verschiedenen Farben vorgesehen sein. Somit ist eine direkte Signalisierung der durch Berührung des Stellstreifens gewählten Eingabe möglich, d.h. durch die Beleuchtung des Stellstreifens kann eine Statusanzeige realisiert werden. Des weiteren kann durch die Beleuchtung des Stellstreifens eine Skala, beispielsweise eine Temperaturskala, visualisiert werden. Werden die Leuchtdioden als Drei-Farben-LEDs mit den Farben "Rot", "Grün" und "Blau" ausgeführt, so können mit Hilfe einer getrennten Ansteuerung der einzelnen Farben mittels einem pulsweitenmodulierten Signal auch Mischfarben angezeigt werden. Weiterhin kann zur Positionskennzeichnung des Stellstreifens an der Oberseite der Abdeckplatte oder bei durchsichtiger Abdeckplatte an deren Unterseite eine Markierung, z.B. in Form eines Aufdrucks angebracht sein.

Ist die Abdeckplatte lichtleitend ausgebildet, so kann auch direkt in die Abdeckplatte Licht im sichtbaren Bereich zur Beleuchtung des Stellstreifens eingekoppelt werden. D.h. die Abdeckplatte kann zur Beleuchtung der Eingabevorrichtung verwendet werden. In diesem Fall kann dann die Abdeckplatte zweckmäßigerweise im Bereich des Stellstreifens Strukturen aufweisen, die bewirken, dass das Licht der Beleuchtung zu einem Betrachter hin abgestrahlt wird. Vorzugsweise sind diese Strukturen an der Oberfläche der Abdeckplatte ausgebildet.

Im den oben genannten Fällen, in denen der Stellstreifen bzw. die Eingabevorrichtung mittels sichtbaren Lichts beleuchtet wird, wird vorzugsweise für die Ausbildung des evaneszenten Feldes Licht einer anderen Wellenlänge verwendet, beispielsweise Infrarotlicht. Auf diese Weise wird die Detektion des zum evaneszenten Feld gehörenden, im Lichtleiter geführten Lichts nicht durch die Beleuchtung gestört. Umgekehrt wird auch die Beleuchtung des Stellstreifens bzw. der Eingabevorrichtung durch das unsichtbare Infrarotlicht nicht beeinflusst.

Der Lichtleiter kann auch von einem Trägermaterial bzw. einer Maske zumindest an den Stellen ummantelt sein, an denen weder Licht ein- noch austreten soll bzw. die nicht zur Ausbildung des durch Berührung des Stellstreifens veränderbaren evaneszenten Feldes vorgesehen sind. Solch eine Ummantelung des Lichtleiters kann beispielsweise bei dem Herstellungsprozess des Lichtleiters mittels Zwei-Komponenten-Spritzgussverfahren erzielt werden. Ist der Lichtleiter von solch einem Trägermaterial ummantelt, so können die für die Montage eventuell vorgesehenen Stütz- und/oder Rastelemente auch an dem Trägermaterial anstatt an oder zusätzlich zu dem Lichtleiter angeformt sein.

Die erfindungsgemäße opto-elektronische Eingabevorrichtung kann insbesondere bei einem Haushaltsgerät der sogenannten "Weißen Ware", wie beispielsweise einer Waschmaschine, einem Wäschetrockner, einer Geschirrspülmaschine, einem Gargerät, wie z.B. einem Herd oder einem Kochfeld, einer Dunstabzugshaube, einem Kältegerät, einem Klimagerät, einem Warmwasserbereiter, einem Kaffeeautomaten oder einem Staubsauger eingesetzt werden. Somit kann das Haushaltsgerät mit einer das Eingabefeld umfassenden durchgängige Blende ausgestattet werden, so dass das Haushaltsgerät gegenüber einem Eintritt von Verschmutzungen oder Feuchtigkeit geschützt ist. Die Blende entspricht dabei der Abdeckplatte und kann beispielsweise aus Metall, Glas, Glaskeramik, Keramik, Naturmaterialien oder Kunststoff gefertigt sein.

Insbesondere kann die Eingabevorrichtung bei einem Kochfeld zur Ansteuerung der Kochstellen eingesetzt werden. Die Abdeckplatte ist hierbei die Glaskeramikplatte des Kochfeldes. Für die Auswahl der Heizleistung jeder Kochstelle kann pro Kochstelle ein separater Stellstreifen vorgesehen sein. Oder es ist gemäß einer anderen Ausführungsform ein einziger Stellstreifen für die Heizleistungsanwahl aller Kochstellen vorgesehen, wobei die Auswahl der jeweils mit dem Stellstreifen anzusteuernden Kochstelle anderweitig vorgenommen wird, zum Beispiel mittels separater Sensortasten. Ist lediglich ein einziger Stellstreifen vorgesehen, so kann durch verschiedenfarbige Beleuchtung des Stellstreifens signalisiert werden, für welche der Kochstelle die Heizleistung eingestellt wird.

Es wird darauf hingewiesen, dass die Merkmale der Unteransprüche ohne Abweichung von der erfindungsgemäßen Idee in beliebiger Weise miteinander kombinierbar sind.

Anhand von Zeichnungen wird die Erfindung nachstehend näher erläutert.
- Fig. 1: zeigt in einer schematischen Querschnittansicht eine opto-elektronische Eingabevorrichtung, bei der ein evaneszentes Feld zur Eingabe verwendet wird,
- Fig. 2: zeigt in einer schematischen Ansicht schräg von oben eine Ausführungsform eines Lichtleiters für einen linearen Stellstreifen,
- Fig. 3: zeigt in einer schematischen Ansicht schräg von oben den auf einer Leiterplatte montierten Lichtleiter gemäß Figur 2,
- Fig. 4: zeigt eine schematische Rückansicht von dem auf der Leiterplatte montierten Lichtleiter gemäß Figur 3,
- Fig. 5: zeigt eine schematische Draufsicht auf den auf der Leiterplatte montierten Lichtleiter gemäß Figur 3 und Figur 4,
- Fig. 6: zeigt in einer schematischen Ansicht schräg von oben eine Ausführungsform eines Lichtleiters für einen ringförmigen Stellstreifen,
- Fig. 7: zeigt in einer schematischen Ansicht schräg von unten den Lichtleiter gemäß Figur 6,
- Fig. 8: zeigt in einer schematischen Ansicht schräg von oben den auf einer Leiterplatte montierten Lichtleiter gemäß Figur 6 und Figur 7,
- Fig. 9: zeigt eine schematische Draufsicht auf den auf der Leiterplatte montierten Lichtleiter gemäß Figur 8.

Bevor auf die Zeichnungen näher eingegangen wird, sei angemerkt, dass einander entsprechende oder gleiche Elemente bzw. Einzelteile bei den verschiedenen Ausführungsformen der opto-elektronischen Eingabevorrichtung gemäß der Erfindung in sämtlichen Zeichnungsfiguren durch gleiche Bezugszeichen bezeichnet sind.

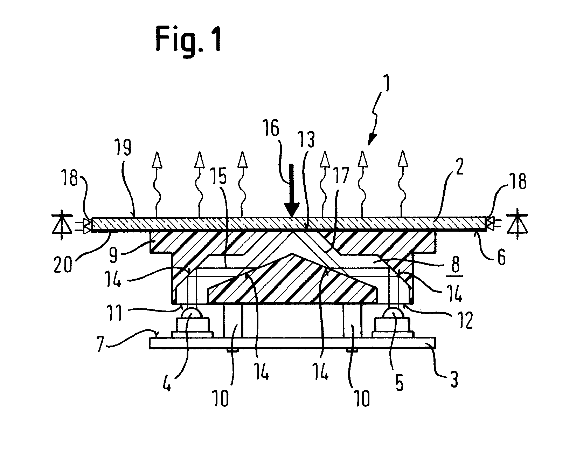

In Fig. 1 ist in einer schematischen Querschnittansicht eine opto-elektronische Eingabevorrichtung 1 gezeigt, bei der eine Störung oder Veränderung eines evaneszenten Feldes zur Auslösung eines Eingabesignals verwendet wird. Die opto-elektronische Eingabevorrichtung 1 weist als Abdeckplatte eine Blende 2 auf, die in diesem Ausführungsbeispiel lichtdurchlässig ausgebildet ist. Die Blende 2 kann beispielsweise aus Glas, Glaskeramik oder lichtdurchlässigem Kunststoff ausgebildet sein. In einem Abstand von der Blende 2 ist eine Leiterplatte 3 positioniert mit einer Lichtquelle 4 in Form einer Leuchtdiode, vorzugsweise einer Infrarotleuchtdiode, die z.B. IR-Licht mit einer Wellenlänge von 950nm abstrahlt, und einem Lichtdetektor 5 in Form einer Fotodiode oder eines Fototransistors entsprechender Wellenlängensensitivität, die auf der der Rückseite 6 der Blende 2 zugewandten Vorderseite 7 der Leiterplatte 3 angeordnet sind. Die Leiterplatte 3 kann eine Kunststoffplatte sein, die z.B. in MID-Technologie ausgebildet ist, und die auf wenigstens einer ihrer Plattenseiten Leiterbahnen aufweist, über die die Lichtquelle 4 und der Lichtdetektor 5 mit einem elektrischen Schaltkreis (nicht gezeigt) der Eingabevorrichtung 1 elektrisch leitend verbunden sind.

Zwischen der Blende 2 und der Leiterplatte 3 ist ein Lichtleiter 8 angeordnet, der in eine lichtundurchlässige Maske 9 eingebettet ist. Dieses aus Lichtleiter 8 und Maske 9 bestehende Lichtleiterbauteil, kann beispielsweise durch zwei Kunststoffkomponenten (2K) in 2K-Spritzgußtechnik gefertigt werden. Dabei wird zuerst aus einer ersten Kunststoffkomponente die Maske 9 gefertigt, in die dann eine zweite Kunststoffkomponente als Lichtleiter 8 eingespritzt wird. Die Materialauswahl unterliegt der Bedingung, dass sich die Maske 9 beim Einspritzen des Lichtleitermaterials nicht wesentlich verformen darf, um die Lichtleiteigenschaft des Lichtleiters 8 nicht zu verschlechtern. Es kann aber auch zuerst der Lichtleiter 8 gefertigt werden, der dann durch das Maskenmaterial ummantelt wird. Dabei sind außer der 2K-Spritzgußtechnik auch andere Fertigungsverfahren möglich.

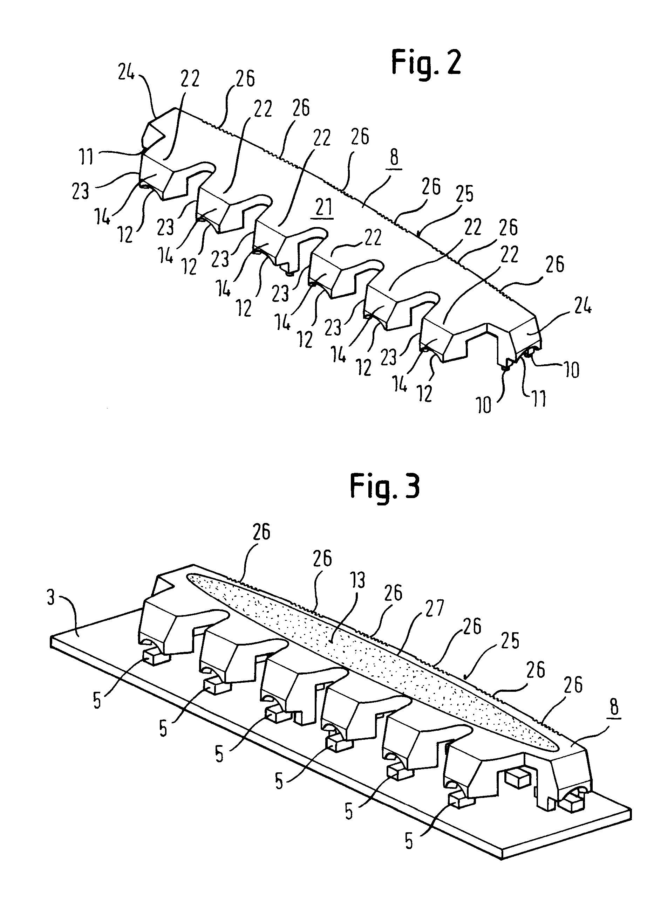

Des weiteren sind an der Maske 9 als Montagehilfe Stifte 10 angeformt, mit denen die Maske 9 und damit der Lichtleiter 8 an der Leiterplatte 3 zum Beispiel durch Heißverstemmen fixiert ist. Es ist auch möglich an der Maske 9 Rastelemente anzuformen, die mit Gegenrastelementen der Leiterplatte 3 verrastet werden, um den Lichtleiter 8 auf der Leiterplatte zu fixieren. Alternativ oder zusätzlich ist es auch möglich Stütz- und/oder Befestigungselemente zwischen der Maske 9 und der Blende 2 vorzusehen. Bei Ausführungsformen der Eingabevorrichtung 1, die auf eine Maske 9 verzichten, können Stütz- und/oder Befestigungselemente direkt an dem Lichtleiter 8 angeformt sein (vgl. Fig. 2, 6 und 7).

Damit die Lichtverluste über die Länge des Lichtleiters 8 möglichst gering bleiben, kann beispielsweise zwischen der Maske 9 und dem Lichtleiter 8 durchgängig ein Luftspalt, insbesondere im Mikrometerbereich ausgebildet werden. Durch diesen Luftspalt wird Licht, das sich in dem Lichtleiter 8 ausbreitet, an der Grenzfläche zum Luftspalt total reflektiert, wodurch das Licht weiter im Lichtleiter 8 geführt und nicht vom Maskenmaterial absorbiert wird. Es ist allerdings auch möglich, das Maskenmaterial bezüglich der Brechzahl derart passenden auszuwählen, dass ein Lichtaustritt aus dem Lichtleiter 8 verhindert wird.

Der Lichtleiter 8 wird von der Maske 9 an den Stellen ummantelt, an denen weder Licht in den Lichtleiter 8 eintreten noch aus dem Lichtleiter 8 austreten soll. Der Lichtleiter 8 weist jedoch einen Lichteingang 11, einen Lichtausgang 12 und eine Sensorfläche 13 auf, die von der Maske 9 frei bleiben, d.h. nicht von Maskenmaterial ummantelt sind. Der Lichteingang 11 ist gegenüber der Position der Lichtquelle 4 angeordnet, so dass Licht, das von der Lichtquelle 4 abgestrahlt wird, über den Lichteingang 11 in den Lichtleiter 8 eingekoppelt wird. Das eingekoppelte Licht 15 wird durch den Lichtleiter 8 geführt, wobei der Lichtleiter 8 mehrere Reflexionsflächen 14 aufweist, an denen das Licht 15 in den Lichtleiter 8 zurück reflektiert wird. Der Lichtausgang 12 ist gegenüber der Position des Lichtdetektors 5 angeordnet, so dass Licht, das über den Lichtausgang 12 aus dem Lichtleiter 8 auskoppelt detektiert werden kann. Die zwischen dem Lichteingang 11 und dem Lichtausgang 12 ausgebildete Sensorfläche 13 ist ebenfalls eine Reflexionsfläche des Lichtleiters 8. Mit dieser Sensorfläche 13 liegt der Lichtleiter 8 plan an der Rückseite 6 der Blende 2 an. Als Licht kann hier beispielsweise Licht im sichtbaren Bereich oder bevorzugt Infrarotstrahlung verwendet werden.

Aufgrund von Oberflächenrauhigkeiten sowohl der Rückseite 6 Blende 2, wie eventuell auch des Lichtleiters 8, bildet sich zwischen der Sensorfläche 13 und der Blende 2 durch die Reflexion des in dem Lichtleiter 8 geführten Lichts 15 an der Sensorfläche 13 ein evaneszentes Feld aus. Bei Berührung der Blende 2 im Bereich der Sensorfläche, die in Figur 1 durch einen Pfeil 16 gekennzeichnet ist, wird der durch die Oberflächenrauhigkeiten gebildete Abstand zwischen der Blende 2 und der Sensorfläche 13 verringert, und damit das evaneszente Feld gestört, so dass ein Teil des in dem Lichtleiter geführten Lichts 15 von dem Lichtleiter 8 über die Sensorfläche 13 aus- und in die Blende 2 einkoppelt. Dadurch wird der Lichtstrom 17 gedämpft, der den Lichtausgang 12 und damit den Lichtdetektor 5 erreicht. Diese Veränderung des Lichtstroms 17 kann anhand des von dem Lichtdetektor 5 erzeugten Ausgangssignals für einen Schaltvorgang genutzt werden. Das hier kurz skizzierte Schalt-Prinzip unter Nutzung der Veränderung bzw. Störung des evaneszenten Feldes ist ausführlich in dem Dokument DE 10 2005 021 008 A1 beschrieben, dessen Offenbarungsgehalt hiermit ausdrücklich in die vorliegende Beschreibung mit aufgenommen wird.

Bei der Ausführungsform gemäß Figur 1 ist vorgesehen, die Blende zur Beleuchtung der Eingabevorrichtung 1 zu nutzen. Dabei ist vorgesehen, in die Stirnseiten 18 der Blende 2 Licht im sichtbaren Bereich einzukoppeln, wie dies in Figur 1 durch schematisch gezeichnete Leuchtdioden gekennzeichnet ist. Zur Realisierung einer homogenen Leuchtdichte innerhalb einer gewünschten beleuchteten Fläche, z.B. im Bereich der Eingabevorrichtung 1 bzw. der Sensorfläche 13, ist die lichtdurchlässige Blende 2 an ihrer Oberseite 19 mit einer Mikrostruktur versehen (nicht gezeigt). Auf diese Weise wird nur im Bereich der Mikrostruktur Licht abgestrahlt, wie durch von der Oberfläche 19 der Blende 2 weg weisende Pfeile gekennzeichnet, so dass einem Betrachter nur dieser Bereich beleuchtet erscheint. Zusätzlich kann noch zwischen der Rückseite 6 der Blende 2 und der Sensorfläche 13 bzw. der Maske 9 eine zusätzliche Zwischenschicht 20 angeordnet sein, beispielsweise in Form einer Reflektorfläche, die auf die Rückseite 6 der Blende 2 aufgebracht ist.

Ein elektrischer Schaltkreis der Eingabevorrichtung 1 zur Ansteuerung der Lichtquelle 4 bzw. zur Auswertung von Signalen des Lichtdetektors 5 kann auf der Vorder- oder Rückseite der Leiterplatte 3 oder auf einer separaten Platine angeordnet sein. Des weiteren kann die Leiterplatte 3 auch die Steuer- bzw. Leistungselektronik des entsprechenden Gerätes umfassen, das mit der Eingabevorrichtung 1 ausgestattet ist, oder die Leiterplatte 3 ist alternativ dazu mit der Steuer- bzw. Leistungselektronik des Gerätes elektrisch leitend verbunden (nicht gezeigt).

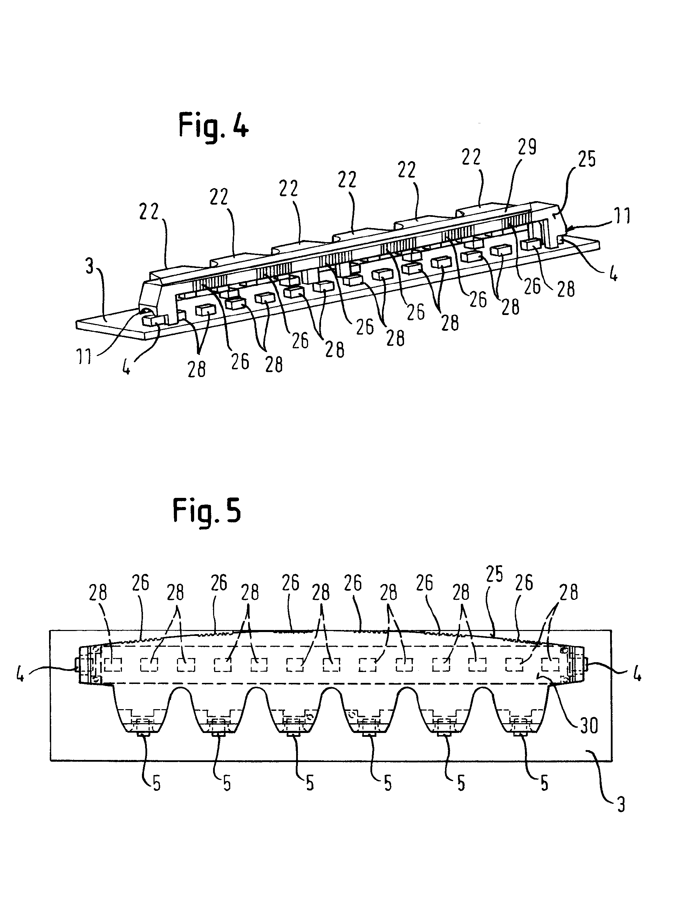

In Figur 2 ist ein Lichtleiter 8 gezeigt, der für einen linearen Stellstreifen geeignet ist. Die Figuren 3 bis 5 zeigen diesen Lichtleiter 8 auf die Leiterplatte 3 montiert einmal schräg von vorne (Figur 3), einmal schräg von hinten (Figur 4) und einmal in Draufsicht (Figur 5). Der Lichtleiter 8 ist kammartig ausgebildet und weist eine Lichtleiterleiste 21 auf, von der aus sechs Lichtleiterfortsätze 22 rechtwinklig abzweigen. Die Lichtleiterfortsätze 22 sind gleichmäßig über die Lichtleiterleiste 21 verteilt und weisen zueinander immer den gleichen Abstand auf. Die Lichtleiterfortsätze 22 münden an ihrem der Lichtleiterleiste 21 abgewandten Ende 23 in je einen Lichtausgang 12, wobei jedem der Lichtausgänge 12 je ein Lichtdetektor 5 zugeordnet ist. Des weiteren weist die Lichtleiterleiste 21 an ihren zwei Enden 24 je einen Lichteingang 11 auf, wobei jedem dieser beiden Lichteingänge 11 je eine Lichtquelle 4 zugeordnet ist. Zusätzlich weist die Lichtleiterleiste 21 an ihrer den Lichtleiterfortsätzen 22 abgewandten Seite 25, jeweils den Lichtleiterfortsätzen 22 gegenüberliegend, Strukturen 26 auf, durch die das in der Lichtleiterleiste 21 geführte Licht in den jeweils gegenüberliegenden Lichtleiterfortsatz 22 abgelenkt wird. Diese Strukturen 26 sind besonders gut in Figur 4 erkennbar. Sie sind beispielsweise dreieckförmig ausgebildet und weisen Reflexionsflächen auf, durch die das in der Lichtleiterleiste 21 geführte Licht in Richtung der Lichtleiterfortsätze 22 und damit der Lichtausgänge 12 reflektiert wird. Damit auch die Lichtausgänge 12 bzw. Lichtleiterfortsätze 22, die von beiden Lichteingängen 11 der Lichtleiterleiste 21 am weitesten entfernt angeordnet sind, mit einer für eine Berührungsdetektion ausreichender Menge an Licht versorgt werden, ist die den Lichtleiterfortsätzen 22 abgewandte Seite 25 der Lichtleiterleiste 21 konvex gewölbt ausgeführt.

In Figur 3 ist die in Form eines Stellstreifens 27 ausgebildete Sensorfläche 13 des Lichtleiters 8 gepunktet angedeutet. Der Stellstreifen 27 ist eventuell an einer über dem Lichtleiter 8 verlaufenden Abdeckplatte oder Blende 2 analog zu Figur 1 gekennzeichnet. Es ist in einer alternativen Ausführungsform auch möglich, dass die Sensorfläche 13 des Lichtleiters 8 auch gleichzeitig die Berührfläche bildet, damit entspricht dann die Sensorfläche 13 dem Stellstreifen 27. An der Sensorfläche 13 bildet sich durch Reflexion des in der Lichtleiterleiste 21 geführten Lichts ein evaneszentes Feld aus, was sich über die gesamte Sensorfläche 13 und damit über den gesamten Stellstreifen 27 erstreckt. Das evaneszente Feld ist, wie bereits oben erläutert, durch Berührung der Eingabevorrichtung 1 im Bereich dieses Stellstreifens 27 veränderbar bzw. störbar, so dass das in die Lichtleiterfortsätze 22 reflektierte Licht gedämpft wird. Diese Dämpfung führt zu einer Änderung, genauer einer Absenkung der Ausgangssignale der Lichtdetektoren 5. Erreicht die Absenkung der Ausgangssignale einen vorgegebenen Wert, so wird eine Betätigung des Stellstreifens erkannt und ein entsprechender Stellwert von der Eingabevorrichtung 1 ausgegeben. Durch die oben beschriebene konvexe Wölbung der den Lichtleiterfortsätzen 22 abgewandten Seite 25 der Lichtleiterleiste 21 und/oder durch die oben erwähnten, mit Reflexionsflächen ausgebildeten Strukturen 26, können die Lichtausgänge 12 des Lichtleiters 8 mittels des von den beiden Lichtquellen 4 in ihren jeweils zugeordneten Lichteingang 11 und somit von beiden Enden 24 der Lichtleiterleiste 21 eingestrahlten Lichts gleichmäßig ausgeleuchtet werden. Durch die Lichteinstrahlung in beide Enden 24 der Lichtleiterleiste 21 wird bei Berührung der Eingabevorrichtung 1 im Bereich des Stellstreifens 27 eine Dämpfung des Lichts vermieden, das über Lichtausgänge 12 austritt, die von einem der Lichteingänge 11 betrachtet hinter der Berührposition liegen. Dadurch ist die Feststellung der Berührposition besonders einfach möglich.

Zur Bestimmung der Berührposition des Stellstreifens, werden die Lichtdetektoren 5 nacheinander, insbesondere in einem zeitlichen Multiplexverfahren, abgefragt. Je nachdem an welcher Position relativ zu der lateralen Ausdehnung der Sensorfläche 13 eine Betätigung durch den Benutzer erfolgt, indem der Benutzer je nach Ausführungsform die Blende 2 oder die Lichtleiterleiste 21 im Bereich des Stellstreifens 27 und damit der Sensorfläche 13 berührt, ist aufgrund der Anordnung der Lichtleiterfortsätze 22 und der Strukturen 26 die Lichtdämpfung in den einzelnen Lichtleiterfortsätzen 22 und damit für die entsprechend zugeordneten Lichtdetektoren 5 unterschiedlich. Somit kann anhand der der jeweiligen Berührungsposition des Stellstreifens zugehörigen Ausgangssignale der Detektoren 5 die Position der Betätigung bestimmt und damit ein dieser Position entsprechender bzw. zugeordneter Schaltzustand ausgelöst werden. Insbesondere kann durch die Auswertung der Ausgangssignale von zwei benachbart angeordneten Lichtdetektoren eine Betätigungsposition zwischen diesen beiden Lichtdetektoren erkannt werden. Bei einer Änderung bzw. Verschiebung der Betätigungsposition, indem beispielsweise der Benutzer seinen Finger auf der Blende 2 oder der Lichtleiterleiste 21 verschiebt, kann diese Verschiebung kontinuierlich detektiert werden und es wird gegebenenfalls ein der neuen Position entsprechender Schaltzustand ausgelöst. In diesem Fall kann auch die Geschwindigkeit der Verschiebung bestimmt werden, die ebenfalls zur Ansteuerung und/oder zum Aufruf von Gerätefunktionen genutzt werden kann. Durch den Stellstreifen 27 nebst zugehörigen Lichtleiter 8 wird somit ein Schiebeschalter ohne mechanisch zu verschiebende Elemente gebildet, durch den beispielsweise eine Temperatur oder eine Leistung bei einem Kochfeld, einem Klimagerät oder einem Kältegerät eingestellt werden kann.

Bei Berücksichtigung der Geschwindigkeit wie sich ein Ausgangssignal des einzelnen Lichtdetektors 5 oder aller Lichtdetektoren 5 ändert, kann überprüft werden, ob eine Betätigung des Stellstreifens 27 vorliegt, oder ob eventuell aufgrund von Verunreinigungen oder Benetzung der Blende 2, aufgrund von Umgebungsbedingungen, wie Temperatur und Feuchtigkeit, oder aufgrund von Alterungsprozessen der Eingabevorrichtung 1 eine Fehlfunktion vorliegt. Eventuell kann der Signalhub des Ausgangssignals durch Änderung der Lichtemission der Lichtquellen 4 dynamisch angepasst werden, d.h. die Eingabevorrichtung 1 kann automatisch kalibriert werden, wodurch die Funktionssicherheit des Stellstreifens verbessert wird. Wird das Ausgangssignal mit Hilfe eines Softwarealgorithmus ausgewertet, so kann auch dessen Auswertelogik an verschiedene Umstände dynamisch angepasst werden, wie beispielsweise an die Lebensdauer, an eventuell auftretende Verschmutzungen oder an verschiedene Geräteprogramme. Wenn aufgrund beispielsweise einer verschmutzten Blende 2 eine sichere Funktion des Annäherungsschalters nicht mehr gewährleistet ist, wird das Haushaltsgerät automatisch abgeschaltet.

Des weiteren können auf der Leiterplatte 3 auf der dem Lichtleiter 8 zugewandten Seite im Bereich des Stellstreifens 27 eine oder mehrere Leuchtelemente 28 (vgl. Fig. 4, 5), beispielsweise in Form von Leuchtdioden, vorgesehen sein, die Licht im sichtbaren Bereich abgeben, um den Stellstreifen 27 zu kennzeichnen oder unterschiedliche Schaltzustände der Eingabevorrichtung 1 zu signalisieren. Diese Leuchtelemente 28 können insbesondere verschiedenfarbiges Licht abgeben, so dass mit Hilfe dieser unterschiedlichen Farben längs des Stellstreifens 27 beispielsweise eine Skala 29, insbesondere eine Temperaturskala, visualisiert werden kann. Wie in Figur 5 zu erkennen ist, sind die Leuchtelemente 28 vorzugsweise im Bereich der Bedienfläche 30 des Stellstreifens 27 angeordnet. Auf diese Weise ist der Bedienfläche 30 direkt eine Statusanzeige zugeordnet.

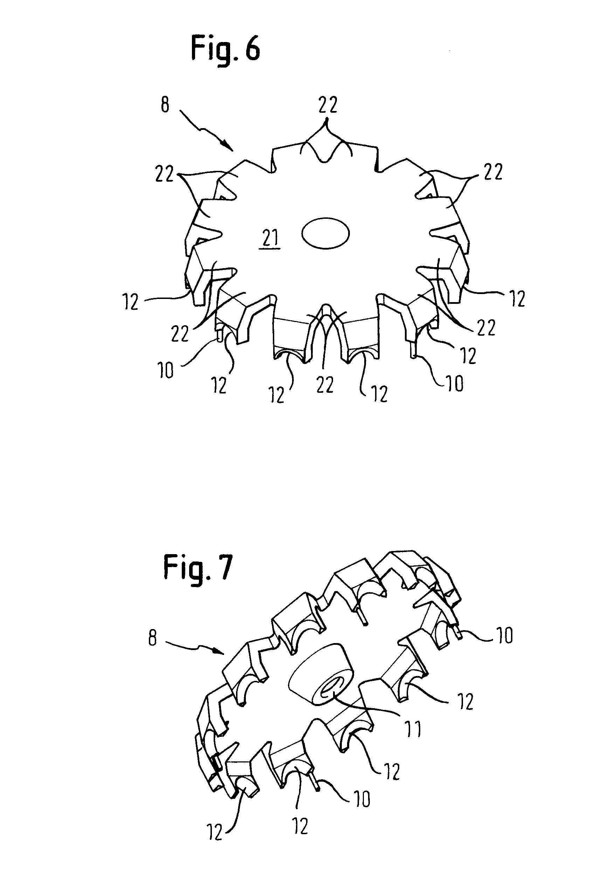

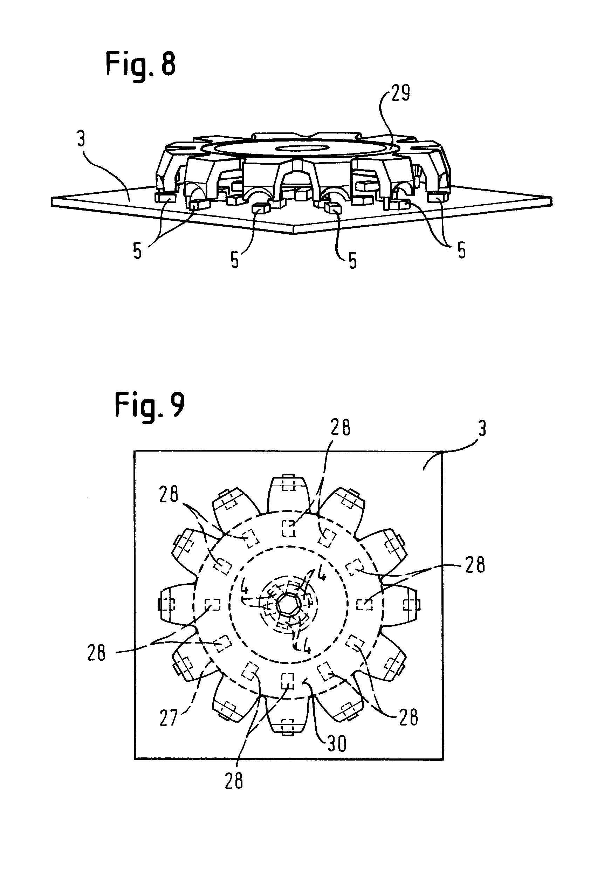

In Figur 6 und 7 ist ein gemäß einer weiteren Ausführungsform ein Lichtleiter 8 gezeigt, der für einen ringförmigen Stellstreifen ausgebildet ist. Die Figuren 6 und 7 zeigen diesen Lichtleiter einmal schräg von oben (Figur 6) und einmal schräg von unten (Figur 7). Die Figuren 8 und 9 zeigen diesen Lichtleiter 8 auf einer Leiterplatte 3 montiert einmal schräg von oben (Figur 8) und einmal in Draufsicht (Figur 9). Der Lichtleiter 8 ist hier insofern auch kammartig ausgebildet, dass von einer ringförmig ausgebildeten Lichtleiterleiste 21 an deren äußeren Umfang zwölf Lichtleiterfortsätze 22 abzweigen. Diese Lichtleiterfortsätze 22 münden analog zu der oben beschriebenen Ausführungsform gemäß Figur 2 bis 5 an ihrem der Lichtleiterleiste 21 abgewandten Ende in je einen Lichtausgang 12. Dieser Lichtausgang 12 ist insbesondere derart ausgebildet, dass das austretende Licht zu dem jeweils zugeordneten Lichtdetektor 5 hin fokussiert wird.

Des weiteren weist die Lichtleiterleiste 21 einen ringförmigen Lichteingang 11 auf, dem mehrere Lichtquellen 4 zugeordnet sind. Diese Lichtquellen 4, die insbesondere auch wieder Leuchtdioden mit im sichtbaren oder im Infrarot liegender Lichtemission sein können, sind ringförmig um den Mittelpunkt des ringförmigen Lichteingangs 11 angeordnet. Gemäß dem in Figur 9 gezeigten Ausführungsbeispiel ist jeweils eine Lichtquelle 4 zur Lichtversorgung von zwei Lichtleiterfortsätzen 22 und damit zwei Lichtdetektoren 5 vorgesehen, so dass dem Lichteingang 11 sechs Lichtquellen 4 zugeordnet sind.

Analog zu der oben beschriebenen Ausführungsform des linearen Stellstreifens 27 können auch bei der kreisförmigen Variante auf der Leiterplatte 3 auf der dem Lichtleiter 8 zugewandten Seite im Bereich des Stellstreifens 27 eine oder mehrere Leuchtelemente 28 (vgl. Fig. 9), beispielsweise in Form von Leuchtdioden, vorgesehen sein, die Licht im sichtbaren Bereich abgeben, um den Stellstreifen 27 zu kennzeichnen oder unterschiedliche Schaltzustände der Eingabevorrichtung 1 zu signalisieren. Diese Leuchtelemente 28 können insbesondere verschiedenfarbiges Licht abgeben, so dass mit Hilfe dieser unterschiedlichen Farben längs des Stellstreifens 27 beispielsweise eine Skala 29, insbesondere eine Temperaturskala oder eine Skala verschiedener Betriebsprogramme, visualisiert werden kann. Wie in Figur 9 zu erkennen ist, sind die Leuchtelemente 28 vorzugsweise im Bereich der Bedienfläche 30 des Stellstreifens 27 angeordnet. Auf diese Weise ist der Bedienfläche 30 direkt eine Statusanzeige zugeordnet.

In Figur 6 und Figur 7 sind an dem Lichtleiter 8 angeformte Stifte 10 zu erkennen, die zur Montage des Lichtleiters 8 auf der Leiterplatte 3 dienen. Durch diese Stifte 10 wird der ringförmige Lichtleiter derart an der Leiterplatte 3 fixiert, dass die Lichtausgänge 12 in einem vorgegebenen Abstand über den Lichtdetektoren 5 und der Lichteingang 11 ebenfalls in einem vorgegebenen Abstand über den Lichtquellen 4 schweben.

### Bezugszeichenliste

- 1: opto-elektronische Eingabevorrichtung
- 2: Blende
- 3: Leiterplatte
- 4: Lichtquelle
- 5: Lichtdetektor
- 6: Rückseite der Blende
- 7: Vorderseite der Leiterplatte
- 8: Lichtleiter
- 9: Maske
- 10: Stift
- 11: Lichteingang
- 12: Lichtausgang
- 13: Sensorfläche
- 14: Reflexionsfläche
- 15: geführtes Licht
- 16: Berührung der Blende
- 17: Lichtstrom
- 18: Stirnseite der Blende
- 19: Oberfläche der Blende
- 20: Zwischenschicht
- 21: Lichtleiterleiste
- 22: Lichtleiterfortsätze
- 23: das der Lichtleiterleiste angewandte Ende des Lichtleiterfortsatzes
- 24: Ende der Lichtleiterleiste
- 25: die den Lichtleiterfortsätzen abgewandte Seite der Lichtleiterleiste
- 26: Strukturen zur Lichtreflexion
- 27: Stellstreifen
- 28: Leuchtelement
- 29: Skala
- 30: Bedienfläche

## Patentansprüche

1. Opto-elektronische Eingabevorrichtung (1), insbesondere für Haushaltsgeräte, mit einer Lichtquelle (4), einem Lichtdetektor (5) und einem Lichtleiter (8), der einen Lichteingang (11) zur Einkopplung von Licht der Lichtquelle (4) und einen Lichtausgang (12) zur Detektion des in dem Lichtleiter (8) geführten Lichts durch den Lichtdetektor (5) aufweist, wobei die Eingabevorrichtung (1) eine Berührfläche (30) aufweist und derart ausgebildet ist, dass durch Berührung der Berührfläche (30) ein evaneszentes Feld des im Lichtleiter (8) geführten Lichts veränderbar und eine daraus folgende Veränderung des in dem Lichtleiter (8) geführten Lichts mit dem Lichtdetektor (5) detektierbar ist, **dadurch gekennzeichnet, dass** die Berührfläche (30) in Form eines Stellstreifens (27) ausgebildet ist, dass sich der Lichtleiter (8) und damit das evaneszente Feld des in dem Lichtleiter (8) geführten Lichts entlang des Stellstreifens (27) erstreckt und dass bei Berührung des Stellstreifens (27) an einer Berührposition diese Berührposition anhand der Veränderung des in dem Lichtleiter (8) geführten Lichts bestimmbar und als Schaltsignal auswertbar ist.

2. Eingabevorrichtung nach Anspruch 1, **dadurch gekennzeichnet, dass** der Lichtleiter (8) mehrere Lichtausgänge (12) aufweist, und dass jedem der Lichtausgänge (12) ein Lichtdetektor (5) zugeordnet ist.

3. Eingabevorrichtung nach Anspruch 2, **dadurch gekennzeichnet, dass** der Lichtleiter (8) eine Formgebung und/oder Strukturen (26) aufweist, so dass der Lichtleiter (8) zur Umlenkung des in dem Lichtleiter (8) geführte Lichts (15, 17) zu den Lichtausgängen (12) hin ausgebildet ist.

4. Eingabevorrichtung nach Anspruch 2 oder 3, **dadurch gekennzeichnet, dass** der Lichtleiter (8) derart kammartig ausgebildet ist, dass er eine Lichtleiterleiste (21) aufweist, die sich entlang des Stellstreifens erstreckt, von der aus Lichtleiterfortsätze (22) abzweigen, deren der Lichtleiterleiste (21) abgewandtes Ende jeweils in einen Lichtausgang (12) mündet.

5. Eingabevorrichtung nach Anspruch 4, **dadurch gekennzeichnet, dass** das durch Berührung des Stellstreifens (27) veränderbare evaneszente Feld durch das in der Lichtleiterleiste (21) geführte Licht gebildet ist.

6. Eingabevorrichtung nach Anspruch 4 oder 5, **dadurch gekennzeichnet, dass** sich die Lichtleiterfortsätze (22) senkrecht zu der Lichtleiterleiste (21) erstrecken.

7. Eingabevorrichtung nach einem der Ansprüche 2 bis 6, **dadurch gekennzeichnet, dass** die Berührposition anhand von Signalen zumindest zweier Lichtdetektoren (5) bestimmbar ist.

8. Eingabevorrichtung nach einem der vorhergehenden Ansprüche, **dadurch gekennzeichnet, dass** der Lichtleiter (8) derart ausgebildet ist, dass das evaneszente Feld entlang des Stellstreifens (27) in Form einer Gleichverteilung ausgebildet ist oder dass das evaneszente Feld entlang des Stellstreifens (27) Maxima und Minima ausbildet oder dass sich das evaneszente Feld entlang des Stellstreifens (27) kontinuierlich verändert.

9. Eingabevorrichtung nach einem der vorhergehenden Ansprüche, **dadurch gekennzeichnet, dass** der Lichtleiter (8) zur Ausbildung des evaneszenten Feldes mehrere Lichteingänge (11) aufweist, denen jeweils eine Lichtquelle (4) zugeordnet ist.

10. Eingabevorrichtung nach einem der vorhergehenden Ansprüche, **dadurch gekennzeichnet, dass** der Lichtleiter (8) zwei Enden mit je einem Lichteingang (11) aufweist, durch den Licht von einer jeweils zugeordneten Lichtquelle (4) in den Lichtleiter (8) einkoppelbar ist.

11. Eingabevorrichtung nach einem der Ansprüche 1 bis 10, **dadurch gekennzeichnet, dass** der Stellstreifen und/oder der Lichtleiter (8) linear oder gebogen ausgebildet ist.

12. Eingabevorrichtung nach einem der Ansprüche 1 bis 9, **dadurch gekennzeichnet, dass** der Stellstreifen (27) und/oder der Lichtleiter (8) ringförmig ausgebildet ist.

13. Eingabevorrichtung nach Anspruch 12, **dadurch gekennzeichnet, dass** der Lichtleiter (8) auf der dem Ringmittelpunkt zugewandten Seite einen oder mehrere Lichteingänge (11) aufweist, und dass der Lichtleiter (8) eine oder mehrere Lichtquellen (4) umgibt.

14. Eingabevorrichtung nach einem der vorhergehenden Ansprüche, **dadurch gekennzeichnet, dass** der Lichtleiter (8) von einer Abdeckplatte (2) abgedeckt ist.

15. Eingabevorrichtung nach Anspruch 14, **dadurch gekennzeichnet, dass** die Abdeckplatte (2) lichtleitend ausgebildet ist, dass das in dem Lichtleiter (8) geführte Licht in die Abdeckplatte (2) einkoppelt und dort geführt wird, und dass das durch Berührung des Stellstreifens (27) veränderbare evaneszente Feld durch das in der Abdeckplatte (2) geführte Licht gebildet ist.

16. Eingabevorrichtung nach Anspruch 15, **dadurch gekennzeichnet, dass** zur Brechzahlanpassung zwischen der Abdeckplatte (2) und dem Lichtleiter (8) eine lichtdurchlässige Zwischenschicht, insbesondere eine Kleberschicht oder eine Haftvermittlerschicht, ausgebildet ist.

17. Eingabevorrichtung nach Anspruch 14, **dadurch gekennzeichnet, dass** zwischen der Abdeckplatte (2) und dem Lichtleiter (8) ein Körper angeordnet ist, durch den bei Berührung der Abdeckplatte (2) im Bereich des Stellstreifens das evaneszente Feld des im Lichtleiter (8) geführten Lichts veränderbar ist.

18. Eingabevorrichtung nach einem der Ansprüche 14 bis 17, **dadurch gekennzeichnet, dass** die Abdeckplatte (2) lichtleitend ausgebildet ist, und dass in die Abdeckplatte (2) sichtbares Licht zur Beleuchtung des Stellstreifens (27) einkoppelbar ist.

19. Eingabevorrichtung nach einem der vorhergehenden Ansprüche, **dadurch gekennzeichnet, dass** an dem Lichtleiter (8) zur Halterung auf einem Träger (3) Stützelemente (10) und/oder Rastelemente angeformt sind.

20. Eingabevorrichtung nach Anspruch 19, **dadurch gekennzeichnet, dass** der Träger (3) eine Leiterplatte ist.

21. Eingabevorrichtung nach Anspruch 20, **dadurch gekennzeichnet, dass** zwischen Leiterplatte (3) und Lichtleiter (8) zumindest ein Leuchtelement (28) zur Beleuchtung des Stellstreifens (27) angeordnet ist.

22. Eingabevorrichtung nach Anspruch 21, **dadurch gekennzeichnet, dass** durch die Beleuchtung des Stellstreifens (27) eine Skala, insbesondere eine Temperaturskala, visualisiert wird.

23. Eingabevorrichtung nach Anspruch 21 oder 22, **dadurch gekennzeichnet, dass** zur Beleuchtung des Stellstreifens (27) Drei-Farben-Leuchtdioden vorgesehen sind.

24. Eingabevorrichtung nach einem der vorhergehenden Ansprüche, **dadurch gekennzeichnet, dass** ein Ausgangssignal des Lichtdetektors (5) automatisch kalibrierbar ist.

25. Eingabevorrichtung nach Anspruch 24, **dadurch gekennzeichnet, dass** zur automatischen Kalibrierung eine Änderungsgeschwindigkeit eines Ausgangssignals des Lichtdetektors (5) auswertbar ist.

26. Eingabevorrichtung nach Anspruch 24 oder 25, **dadurch gekennzeichnet, dass** zur Kalibrierung eine Lichtemission der Lichtquelle (4) veränderbar ist.

27. Eingabevorrichtung nach einem der vorhergehenden Ansprüche, **dadurch gekennzeichnet, dass** der Stellstreifen (27) mittels Software an unterschiedliche Gerät und/oder unterschiedliche Betriebszustände und/oder unterschiedliche Betriebsprogramme anpassbar ist.

28. Haushaltsgerät, insbesondere Kochfeld, mit einer Eingabevorrichtung (1) nach einem der Ansprüche 1 bis 27.
